# EUROPEAN PATENT SPECIFICATION

(11) **EP 0 301 559 B1**
(45) Date of publication and mention of the grant of the patent: **04.05.1994**
(21) Application number: 88112295.6
(22) Date of filing: 29.07.1988
(51) Int. Cl.: G03F 7/09

(54) **Spin castable mixtures useful for making deep-UV contrast enhancement layers**
Schleudergiessbare Mischungen für die Herstellung von Schichten mit erhöhtem Kontrast im tiefen UV-Licht
Mélanges pour la fabrication de couches pour augmenter le contraste dans l'UV profond susceptibles d'application à la girouette

(30) Priority: 31.07.1987 US 79988
(43) Date of publication of application: 01.02.1989
(73) Proprietor: MicroSi, Inc. (a Delaware corporation), Phoenix Arizona 85044 (US)
(72) Inventor: David, Gary Charles, Albany New York 12205 (US)
(74) Representative: Green, Mark Charles

(56) References cited:
- GB-A- 1 175 733
- US-A- 4 677 049

## Description

As shown in U.S. Patent No. 4,677,079, Griffing et al., diarylnitrones are used as photobleachable compounds to make near-UV (350-450 nm) contrast enhancement lithographic compositions. Mid-UV imaging areas (300-350 nm), have been satisfied with certain α-aryl-N-alkyl nitrones. Recently, efforts have been made to apply contrast enhancement capability to photoresists in the deep-UV regions of 200-300 nm.

At the present time, the only known nitrones which absorb in the 200-300 nm region are dialkylnitrones. However, most dialkylnitrones either quickly hydrolyze and/or dimerize. It would be desirable, therefore, to find organonitrones useful in the deep-UV region which are stable in solution.

The present invention is based on my discovery that certain α-alkyl-N-alkyl nitrones having the formula, 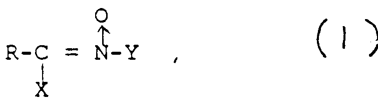
can be used as photobleachable dyes to provide deep UV contrast enhancement layers (CEL) in photolithographic applications, where R is selected from hydrogen and a C₍₁₋₈₎ alkyl radical, X is a monovalent radical selected from hydrogen and an electron withdrawing radical selected from the class consisting of carbalkoxy, acyl and oxirane, Y is a monovalent aliphatic group selected from R¹, and 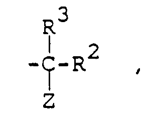
R¹ is a C₍₁₋₈₎ alkyl radical, R² and R³ are monovalent radicals selected from hydrogen and C₍₁₋₈₎ alkyl, Z is a member selected from hydrogen, C₍₁₋₈₎ alkyl radical or an electron withdrawing radical selected from the class consisting of nitrile, carbalkoxy, and acyl, and R and/or Y can be a C₍₃₋₅₎ divalent alkylene radical, or a C₍₃₋₅₎ divalent alkylene radical substituted with one to three monovalent radicals, or a mixture thereof selected from the class consisting of cyano, halogen, carbalkoxy, nitro, amino, and alkylamino, which divalent radicals together can form a C₍₅₋₇₎heterocyclic ring.

There is provided by the present invention, spin castable mixtures useful for applying contrast enhancement layers (CEL) on photoresists capable of absorbing in the 200-300 nm region comprising by weight,
(A) 100 parts inert solvent,
(B) 5 to 20 parts of inert organic binder, and
(C) 5 and 20 parts of α-alkyl-N-alkyl nitrone of formula (1) as defined above.

Alkyl radicals included by R, R¹, and R² of formula (1) are, for example, methyl, ethyl, propyl, butyl, pentyl, hexyl, heptyl, and octyl. Electron withdrawing radicals included within X of formula (1) are, for example, carbalkoxy and carbonyl. Electron withdrawing radicals included within Z of formula (1) are, for example, nitrile, carbalkoxy and carbonyl.

Some of the dialkyl nitrones which can be used in the practice of the present invention are, for example,
α-isopropyl-N-α-cyanobutyryl nitrone,
α-methylpyruvate-N-isopropyl nitrone,
isopropylglyoxalnitrone oxaziridine,
2,2,5-trimethyl-Δ¹-pyrroline-1-oxide,
ethylglyoxalnitrone oxaziridine,
α-ethylpyruvate-N-methylnitrone,
α-ethylpyruvate-N-isopropylnitrone,
α-methylpyruvate-N-cyclohexylnitrone,
2,5-dimethyl-5-carbethoxy-Δ¹-pyrroline-1-oxide,
4,5,5-trimethyl-Δ¹-pyrroline-1-oxide, and
2-cyano-4,5,5-trimethyl-Δ¹-pyrroline-1-oxide.

Among the solvents which can be used to make these spin castable mixtures of the present invention are, for example, water, and organic solvents such as, butanol particularly 1-butanol and ethylbenzene.

Suitable binders which can be utilized in the practice of the present invention are, for example, polyvinylpyrrolidone, hydroxypropylcellulose, polystyrene, copolymers of vinylpyrrolidone with vinylacetate, copolymers of styrene with vinylalcohol.

An additional aspect of the present invention is directed to composites useful for making patterned photoresists with improved resolution using deep-UV irradiation, comprising a photoresist and a (CEL) layer thereon, where the contrast enhancement layer is made from a spin castable mixture comprising the above-described spin castable CEL compositions. The composites can have a photoresist layer with thicknesses of from .2 to 5 microns and, preferably, .5 to 2 microns, while the CEL layer can be from .1 to 2 microns and preferably .2 to 1 micron.

In a further aspect of the present invention, there is provided a method for making patterned photoresists which comprises,
(i) spin casting the spin-castable mixture as defined above onto the surface of a photoresist to produce a CEL-photoresist composite,
(ii) projecting an aerial image utilizing UV light (200-300 nm) onto the surface of CEL-photoresist composite of (i)
(iii) stripping the resulting photobleached CEL layer from the surface of the photoresist, and
(iv) developing the photoresist layer.

Techniques which can be applied to project an aerial image onto the surface of the CEL-photoresist composite are shown by U.S. Patent 4,677,049 (Griffing et al.). COMPOSITIONS

The term "inert", with respect to the above-shown organic polymer binders, means the ability of the binder to form a photobleachable layer with the alkylnitrone of formula (1) which, upon being photobleached, can be readily removed simultaneously with or separately from the surface of the photoresist by stripping with a solvent. In instances where the solvent, for example, n-butanol, may attack the photoresist, a barrier coat, such as polyvinylalcohol can be used between the photoresist and CEL.

The stripping of the photobleached CEL can occur as a separate step prior to developing the photoresist, or it can occur simultaneously with the development of the photoresist. In the latter situation, a water soluble inert organic binder can be used as part of an aqueous spin castable mixture. In instances where an organic solvent is used in the spin castable CEL mixture, stripping of the CEL prior to photoresist development can be required. Any suitable organic solvent, which does not affect the photoresist surface, can be utilized to effect the removal of the photobleached CEL from the photoresist. However, it is preferred to utilize an organic solvent such as toluene, trichloroethylene, chlorobenzene, or mixtures with anisole, taught by P.R. West in U.S. Patent No. 4,623,611,

Additional photoresists which can be used in the practice of the present invention in combination with the above-described spin castable compositions are, for example, Shipley 2400 series, and recently described deep-UV onium salt resists.

The invention includes composites comprising a contrast enhancement layer and a photoresist layer, where the contrast enhancement layer is obtained from the spin castable mixture defined above

In order that those skilled in the art will be better able to practice the invention, the following examples are given by way of illustration and not by way of limitation. All parts are by weight.

### EXAMPLE 1

A solution of 1.14 grams (10 millimoles) of α-hydroxyaminoisobutyronitrile and 10 ml of methylene chloride was treated with 0.72 grams (10 millimoles) of isobutyraldehyde and 1.0 grams of sodium sulfate. After stirring for 16 hours, the solution was filtered, the solvent evaporated under reduced pressure and the residue was triturated with ether. There was obtained 1.02 grams (55%) yield of a white solid of 92-93°C, λ max=243, ε=9800. Based on method of preparation and the aforementioned spectral data, the material was α-isopropyl N-α-cyanobutyryl nitrone.

A mixture of 10 parts of the above nitrone, 10 parts of a copolymer of vinylacetate and vinylpyrrolidone and 80 parts of 1-butanol was spun at 3000 rpm for 25 seconds onto a Shipley 2417 photoresist having a thickness of 0.5 microns which had been previously coated with a 500 Angstrom polyvinylalcohol barrier layer. The Shipley photoresist had previously been applied onto a silicon wafer. The treated silicon wafer was exposed for 14 seconds on a Suss MA-56 printer using UV-250nm mode. The wafer was then rinsed in water and developed for one minute in Shipley 351 developer diluted 3:1 with water. A similar wafer without the nitrone CEL was exposed for 7 seconds, rinsed with water, and similarly developed. Comparison of the wafers by scanning electron microscopy showed that the CEL had improved the contrast of the photoresist.

### EXAMPLE 2

A solution of 0.75 grams (10 millimoles) of isopropylhydroxylamine and 10 ml of methylene chloride was treated with 1.02 grams (10 millimoles) of methyl pyruvate. The mixture was stirred at room temperature for 19 hours and dried with magnesium sulfate. Upon evaporation of the methylene chloride under reduced pressure, a liquid product was isolated which weighed 1.2 grams (75%), λ max = 271, and ε = 12,700. Based on method of preparation and the aforementioned spectral data, the product was α-methylpyruvate-N-isopropyl nitrone.

A formulation of 10% by weight of the above nitrone, 10% by weight of hydroxypropylcellulose in 1-butanol was spun onto a quartz disk at 4000 rpm over a 30-second period. The resulting film showed a 0% transmission from 253-289 nm, 1% transmission from 248-293 nanometers, and a 5% transmission from 240-296 nanometers. The film was bleached utilizing a 1000 Watt lamp operating at 10% of full output and film transmittance was followed as a function of time at 270nm. It was found that the resulting CEL had excellent bleaching characteristics. The nitrone was found to be stable in solution for an indefinite period of time at ambient temperatures.

### EXAMPLE 3

The vigorously stirred mixture of 7.05 grams (44 millimoles) of 5-methyl-5-nitro-2-hexanone and 1.95 grams (36 millimoles) of ammonium chloride in 65 ml of water, cooled to 0-10° centigrade was treated with 9.75 grams (149 millimoles) of zinc dust over 1.5 hour period, keeping the reaction temperature under 10°C. The zinc oxide was filtered and washed with 25 ml of hot water (combined aqueous layers were stripped at 70-75°C.) The resulting residue was treated with chloroform followed by potassium carbonate and magnesium sulfate. After filtration, the mixture was stripped and the product distilled at 60°C, 1 millimeter to provide 4.07 grams (73% of 2,2,5-trimethyl-Δ¹-pyrroline-1-oxide. The nitrone has a λ max = 229 nanometers, ε = 8400.

Formulation of 7.5% of the above nitrone and 5% of hydroxypropylcellulose and 2-butanol was spun onto a quartz disk at 4000 rpm/30 seconds. The resulting film showed 0% transmission from 221-244 nanometers, less than 1% transmission from 217-247 nanometers, and less than 5% transmission from 212-253 nanometers. The film was bleached at 10% of full arc intensity and the UV film transmittance was measured as a function of time at 230nm. It was found that the resulting CEL had excellent bleaching characteristics.

Although the above examples are directed to only a few of the very many variables which can be used in the practice of the present invention, it should be understood that the present invention is directed to a much broader variety of dialkylnitrones in spin castable mixtures obtained therefrom as shown in the description preceding these examples.

## Claims

1. Spin castable mixtures useful for applying contrast enhancement layers on photoresists capable of absorbing in the 200-300nm region comprising, by weight,
(A) 100 parts of inert solvent,
(B) 2 to 20 parts of inert organic binder, and
(C) 2 to 20 parts of α-alkyl-N-alkyl nitrone of the formula, 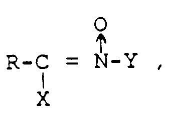
where R is selected from hydrogen and a C₍₁₋₈₎ alkyl radical, X is a monovalent radical selected from hydrogen and an electron withdrawing radical selected from the class consisting of carbalkoxy, acyl and oxirane, Y is a monovalent aliphatic group selected from R¹, and 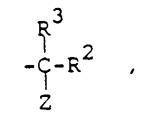 R¹ is a C₍₁₋₈₎ alkyl radical, R² and R³ are monovalent radicals selected from hydrogen and C₍₁₋₈₎ alkyl, Z is a member selected from hydrogen, C₍₁₋₈₎ alkyl radical or an electron withdrawing radical selected from the class consisting of nitrile, carbalkoxy and acyl, and R and/or Y can be a C₍₃₋₅₎ divalent alkylene radical, or a C₍₃₋₅₎ divalent alkylene radical substituted with one to three monovalent radicals, or a mixture thereof selected from the class consisting of cyano, halogen, carbalkoxy, nitro, amino, and alkylamino, which divalent radicals together can form a C₍₅₋₇₎ heterocyclic ring.

2. A spin castable mixture in accordance with claim 1, where the α-alkyl-N-alkyl nitrone is α-isopropyl-N-α-cyanoisobutyryl nitrone.

3. A spin castable mixture in accordance with claim 1, where the α-alkyl-N-alkyl nitrone is 2,2,5-trimethyl-Δ¹-pyrroline-1-oxide.

4. A spin castable mixture in accordance with claim 1, where the α-alkyl-N-alkyl nitrone is α-methylpyruvate-N-isopropyl nitrone.

5. A spin castable mixture in accordance with claim 1, where the inert organic binder is hydroxypropyl cellulose.

6. A spin castable mixture in accordance with claim 1, where the solvent is water.

7. A spin castable mixture in accordance with claim 1, where the solvent is 1-butanol.

8. A method for making patterned photoresist which comprises,
(i) spin casting the spin castable mixture of claim 1 onto the surface of a photoresist to produce a contrast enhancement layer-photoresist composite,
(ii) projecting an aerial image utilizing UV light (200-300 nm) onto the surface of the composite of (i),
(iii) stripping the resulting photobleached contrast enhancement layer from the surface of the photoresist, and
(iv) developing the photoresist layer.

9. Composites comprising a contrast enhancement layer and a photoresist layer where the contrast enhancement layer is obtained from the spin castable mixture of claim 1.

## Patentansprüche

1. Schleudergießbare Mischungen für die Anbringung von Kontrastvergrößerungsschichten an Photoresisten, welche für eine Absorption in dem 200 - 300 nm-Bereich fähig sind, bestehend aus
(A) 100 Gewichtsteilen eines inerten Lösungsmittels,
(B) 2 bis 20 Gewichtsteilen eines inerten organischen Bindemittels und
(C) 2 bis 20 Gewichtsteilen eines α-Akyl-N-Alkylnitrons der Formel 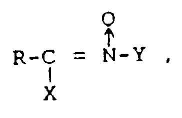
worin R ausgewählt ist von Wasserstoff und einem C₍₁₋₈₎ Alkylradikal, X ein monovalentes Radikal ist, ausgewählt von Wasserstoff und einem Elektronen abziehenden Radikal, ausgewählt von der Klasse, bestehend aus Carbalkoxy, Acyl und Oxiran, Y eine monovalente aliphatische Gruppe ist, ausgewählt von R¹ und 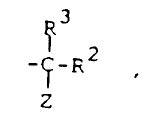 wobei R¹ ein C₍₁₋₈₎ Alkylradikal ist, R² und R³ monovalente Radikale sind, ausgewählt von Wasserstoff und C₍₁₋₈₎ Alkyl, Z ein Glied ist, ausgewählt von Wasserstoff, C₍₁₋₈₎ Alkylradikal oder ein Elektronen abziehendes Radikal, ausgewählt von der Klasse, bestehend aus Nitril, Carbalkoxy und Acyl, und R und/oder Y ein C₍₃₋₅₎ bivalentes Alkylenradikal sein können oder ein C₍₃₋₅₎ bivalentes Alkylenradikal substituiert mit einem bis drei monovalenten Radikalen oder ein Gemisch davon, ausgewählt von der Klasse, bestehend aus Cyan, Halogen, Carbalkoxy, Nitro, Amino und Alkylamino, wobei die bivalenten Radikale Zusammen einen C₍₃₋₇₎ heterocyklischen Ring bilden können.

2. Schleudergießbare Mischung nach Anspruch 1, bei welcher das α-Alkyl-N-Alkylnitron α-Isopropyl-N-α-Cyanisobutyrylnitron ist.

3. Schleudergießbare Mischung nach Anspruch 1, bei welcher das α-Alkyl-N-Alkylnitron 2,2,5-Trimethyl-Δ¹-Pyrrolin-1-Oxid ist.

4. Schleudergießbare Mischung nach Anspruch 1, bei welcher das α-Alkyl-N-Alkylnitron α-Methylpyruvat-N-Isopropylnitron ist.

5. Schleudergießbare Mischung nach Anspruch 1, bei welcher das inerte organische Bindemittel Hydroxypropyl-Cellulose ist.

6. Schleudergießbare Mischung nach Anspruch 1, bei welcher das Lösemittel Wasser ist.

7. Schleudergießbare Mischung nach Anspruch 1, bei welcher das Lösemittel 1-Butanol ist.

8. Verfahren zur Herstellung eines gemusterten Photoresisten, bestehend aus
(i) einem Schleudergießen der schleudergießbaren Mischung nach Anspruch 1 auf die Oberfläche eines Photoresisten zur Erzeugung eines Kontrastvergrößerungsschicht-Photoresist-Verbundes,
(ii) einer Projektion eines Luftbildes unter Verwendung von UV-Licht (200-300 nm) auf die Oberfläche des Verbundes nach (i),
(iii) Entstrippen der resultierenden photogebleichten Kontrastvergrößerungsschicht von der Oberfläche des Photoresist und
(iv) Entwickeln der Photoresistschicht.

9. Verbundstoffe, bestehend aus einer Kontrastvergrößerungsschicht und einer Photoresistschicht, wobei die Kontrastvergrößerungsschicht von der schleudergießbaren Mischung des Anspruchs 1 erhalten ist.

## Revendications

1. Mélange d'application à la girouette utile pour une application à des couches améliorant le contraste sur des photoréserves capables d'absorber dans la région de 200 à 300 nm, comprenant, en poids,
(A) 100 parties de solvant inerte,
(B) 2 à 20 parties de liant organique inerte, et
(C) 2 à 20 parties d'α-alkyl-N-alkylnitrone de formule 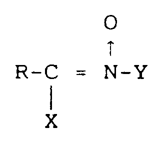
où R est choisi parmi un atome d'hydrogène et un radical alkyle en C₁ à C₈, X est un radical monovalent choisi parmi l'hydrogène, et un radical attracteur d'électron choisi dans la classe constituée des groupes carbalkoxy, acyle et oxirane, Y est un groupe aliphatique monovalent choisi parmi R¹, et 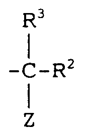 R¹ est un radical alkyle en C₁ à C₈, R² et R³ sont des radicaux monovalents choisis parmi un atome d'hydrogène et un groupe alkyle en C₁ à C₈, Z est un élément choisi parmi un atome d'hydrogène, un radical alkyle en C₁ à C₈ ou un radical attracteur d'électron choisi dans la classe constituée de groupes nitrile, carbalkoxy, et acyle, et R et/ou Y peuvent être un radical alkylène divalent en C₃ à C₅, ou un radical alkylène divalent en C₃ à C₅ substitué avec 1 à 3 radicaux monovalents, ou un de leur mélange choisi dans la classe formée des groupes cyano, halogéno, carbalkoxy, nitro, amino et alkylamino, radicaux divalents qui peuvent former ensemble un cycle hétérocyclique en C₅ à C₇.

2. Mélange d'application à la girouette selon la revendication 1, dans lequel l'α-alkyl-N-alkylnitrone est l'α-isopropyl-N-α-cyanoisobutyrylnitrone.

3. Mélange d'application à la girouette selon la revendication 1, dans lequel l'α-alkyl-N-alkylnitrone est le 2,2,5-triméthyl Δ¹-pyrroline-1-oxyde.

4. Mélange d'application à la girouette selon la revendication 1, dans lequel l'α-alkyl-N-alkylnitrone est l'α-méthylpyruvate-N-isopropylnitrone.

5. Mélange d'application à la girouette selon la revendication 1, dans lequel le liant organique inerte est l'hydroxypropylcellulose.

6. Mélange d'application à la girouette selon la revendication 1, dans lequel le solvant est de l'eau.

7. Mélange d'application à la girouette selon la revendication 1, dans lequel le solvant est le 1-butanol.

8. Procédé pour fabriquer des photoréserves dessinées qui comprend,
(i) l'application à la girouette du mélange d'application à la girouette selon la revendication 1 sur la surface d'une photoréserve pour produire un composite photoréserve-couche améliorant le contraste,
(ii) la projection d'une image aérienne utilisant une lumière UV (200 à 300 nm) sur la surface de (i)
(iii) l'enlèvement de la couche d'amélioration du contraste photoblanchi résultante de la surface de la photoréserve, et
(iv) le développement de la couche de photoréserve.

9. Composite comprenant une couche améliorant le contraste et une couche de photoréserve, dans lequel la couche améliorant le contraste est obtenue à partir du mélange d'application à la girouette selon la revendication 1.
